(19) **European Patent Office / Europäisches Patentamt / Office européen des brevets**

(11) **EP 4 528 294 A1**

(12) **EUROPEAN PATENT APPLICATION**
published in accordance with Art. 153(4) EPC

(43) Date of publication:
**26.03.2025 Bulletin 2025/13**

(21) Application number: **23807848.9**

(22) Date of filing: **12.05.2023**

(51) International Patent Classification (IPC):
**G01R 31/08** $^{(2020.01)}$      **H05B 3/56** $^{(2006.01)}$

(52) Cooperative Patent Classification (CPC):
**G01R 31/08; H05B 3/56**

(86) International application number:
**PCT/KR2023/006513**

(87) International publication number:
**WO 2023/224328 (23.11.2023 Gazette 2023/47)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **16.05.2022 KR 20220059498**

(71) Applicant: **Korea Hydro & Nuclear Power Co., Ltd Gyeongju-si, Gyeongsangbuk-do 38120 (KR)**

(72) Inventors:
• **PARK, Kyungheum**
  **Daejeon 34101 (KR)**
• **JANG, Kyungnam**
  **Daejeon 34101 (KR)**
• **YANG, Chang-Keun**
  **Daejeon 34101 (KR)**

(74) Representative: **De Vries & Metman**
  **Overschiestraat 180**
  **1062 XK Amsterdam (NL)**

(54) **SYSTEM AND METHOD FOR MONITORING AGING STATE OF POWER CABLE**

(57)    The present invention relates to a system and method for monitoring the aging state of a power cable, in which a measuring unit measures the elongation at break of at least one power cable, a data generation unit generates a relational expression on the basis of the elongation at break of each of a heated cable, to which voltage has been applied to raise the temperature thereof, and a non-heated cable, to which no voltage has been applied, from among the measured cables, and an aging state derivation unit derives the aging state of a target power cable by calculating the elongation at break of the target power cable, of which the aging state is to be monitored, by using the relational expression. Accordingly, it is possible to verify the aging state of a power cable quickly and efficiently and to improve the credibility of the aging state of the power cable.

FIG. 1

## Description

### Technical Field

The present disclosure relates to a system and a method for monitoring the age state of a cable, and to a technology that considers self-heating of a power cable to monitor the age state of the cable.

### Background Art

Power cables are used to transmit power from power plants to homes and buildings, and aging evaluation thereof is required to be performed periodically to minimize power loss due to resistance depending on the age states of the cables.

Cable deposit is used as a method of cable aging condition monitoring to predict and evaluate the aging condition of cables.

Cable deposit is a method of placing a cable specimen at the same location as a cable whose condition is to be monitored, making the cable specimen to be in the same condition as an actual aging condition of a cable in the field, recovering the specimen after a predetermined period of time, and measuring an aging condition thereof in a laboratory.

However, monitoring an aging condition by cable deposit does not consider an Ohm heating effect caused by cable resistance generated in power cables, etc., so there is a problem in that measurement results are unreliable.

To solve this problem, a method for monitoring the aging condition of a cable that considers self-heating thereof due to resistance of the cable is proposed.

[Document of Related Art]

[Patent Document] Korean Patent No. 10-0880440 (2009.01.29)

### Disclosure

### Technical Problem

The present disclosure may provide a system and a method for monitoring the age state of a cable, in which an age state due to self-heating is able to be monitored by power applied to a power cable.

### Technical Solution

According to an aspect of the present disclosure, a system for monitoring an age state of a power cable includes a measuring unit configured to measure elongation at break of at least one power cable, a data generation unit configured to generate a relational expression by using elongation at break of each of a heated cable to which a voltage is applied to raise a temperature thereof and a non-heated cable to which no voltage is applied, among the measured power cables, and an age state derivation unit configured to derive an age state of a target power cable by calculating elongation at break of the target power cable whose age state is to be monitored by using the relational expression.

Preferably, the target power cable may be a non-heated cable exposed for a predetermined period of time to a location adjacent to a power cable to which a voltage is applied.

Preferably, the data generation unit may generate a graph showing a change in an age state over time by using the elongation at break of each of the heated cable and the non-heated cable.

Preferably, the age state derivation unit may derive an aging rate according to a temperature of the heated cable and a temperature of the non-heated cable.

Preferably, the age state derivation unit may derive elongation at break of a non-heated cable corresponding to the elongation at break of the target power cable and calculate the derived elongation at break of the non-heated cable by using the relational expression to derive elongation at break of a heated cable.

Preferably, the heated cable may be a power cable with a temperature of 70°C to 110°C, and the non-heated cable may be a power cable with a temperature of 20°C to 60°C.

Preferably, the age state may be derived in any one unit of seconds, minutes, hours, days, months, and years.

According to another aspect of the present disclosure, a method for monitoring the age state of a power cable includes measuring, by a measuring unit, elongation at break of at least one power cable, generating data by a data generation unit generating a relational expression by using elongation at break of each of a heated cable to which a voltage is applied to raise a temperature thereof and a non-heated cable to which no voltage is applied, among the measured power cables, and deriving, by an age state derivation unit, an age state of a target power cable by calculating elongation at break of the target power cable whose age state is to be monitored by using the relational expression.

**Advantageous Effects**

According to the present disclosure, it is possible to verify the age state of a power cable quickly and efficiently, and to improve the reliability of the age state of the power cable.

**Description of Drawings**

FIG. 1 is a configuration diagram of the system for monitoring the age state of a power cable according to an embodiment.
FIG. 2 is a graph illustrating the age state of each of a heated cable and a non-heated cable according to an embodiment.
FIG. 3 is a flowchart illustrating a method for monitoring the age state of a power cable according to an embodiment.

**Best Mode**

Hereinafter, a system and a method for monitoring the age state of a cable according to the present disclosure will be described in detail with reference to the accompanying drawings. In this process, the thickness of lines or sizes of components shown in the drawings may be exaggerated for clarity and convenience of explanation. In addition, terms to be described below are terms defined in consideration of functions in the present disclosure, and may vary depending on an operator's intention or practice. Therefore, definitions of these terms should be made on the basis of contents throughout this specification.

The purpose and effect of the present disclosure may be naturally understood or made clearer by the description below, and the purpose and effect of the present disclosure are not limited to the description below. Additionally, when explaining the present disclosure, when it is determined that a detailed description of the publicly known technology related to the present disclosure may unnecessarily obscure the gist of the present disclosure, detailed description thereof will be omitted.

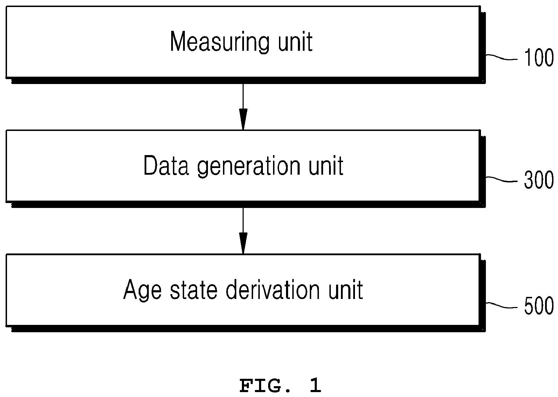

FIG. 1 is a configuration diagram of the system for monitoring the age state of a power cable according to an embodiment.

As illustrated in FIG. 1, the system for monitoring the age state of a power cable according to the embodiment may include a measuring unit 100, a data generation unit 300, and an age state derivation unit 500.

The measuring unit 100 measures the elongation at break of at least one power cable.

The data generation unit 300 generates a relational expression by using the elongation at break of each of a heated cable to which a voltage is applied to raise a temperature thereof and a non-heated cable to which no voltage is applied among the measured power cables.

Here, the data generation unit 300 may generate a graph showing a change in an age state over time by using the elongation at break of each of the heated cable and the non-heated cable.

The age state derivation unit 500 derives the age state of a target power cable by calculating the elongation at break of the target power cable whose age state is to be monitored by using the relational expression.

Here, the target power cable may be a non-heated cable exposed for a predetermined period of time to a location adjacent to a power cable to which a voltage is applied.

In addition, the age state derivation unit 500 may derive an aging rate according to the temperature of the heated cable and the temperature of the non-heated cable.

The age state derivation unit 500 may derive the elongation at break 10 of the non-heated cable corresponding to the elongation at break of the target power cable, and may calculate the derived elongation at break 10 of the non-heated cable by using the relational expression to derive the elongation at break 20 of the heated cable.

In this case, the heated cable may be a power cable with a temperature of 70°C to 110°C, and the non-heated cable may be a power cable with a temperature of 20°C to 60°C.

The age state may be derived in any one unit of seconds, minutes, hours, days, months, and years.

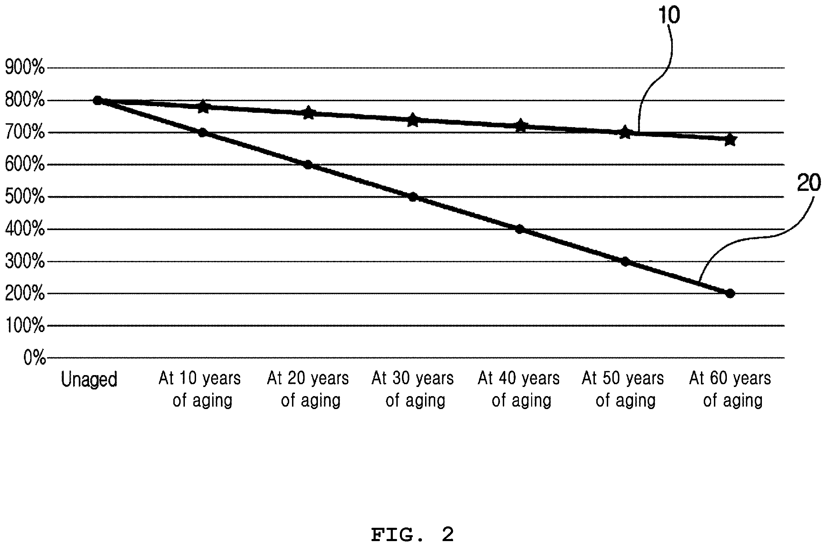

FIG. 2 is a graph illustrating the age state of each of a heated cable and a non-heated cable according to an embodiment.

As illustrated in FIG. 2, the age state of each of the heated cable and the non-heated cable according to an embodiment may be derived by measuring the elongation at break (EAB) of each power cable. Here, the elongation at break over time may be derived for each temperature of the power cable. That is, among power cables, when comparing the elongation at break 20 of the heated cable having a temperature increased due to the application of power, and the elongation at break 10 of the non-heated cable to which no power is applied, the elongation at break 20 of the heated cable having the temperature increased due to the application of power decreases rapidly over time, compared to the elongation at break 10 of the non-heated cable to which no power is applied.

The rapid decrease of the elongation at break 20 of the heated cable indicates that as a temperature thereof increases, an aging rate thereof increases, and it is possible to more precisely observe the age state of a power cable whose age state is to be monitored by considering heating caused by the application of power.

In this case, the temperature of the power cable may be 70°C to 110°C for the heated cable and 20°C to 60°C for the non-heated cable. More preferably, the heated cable may be assumed to have 90°C, and the non-heated cable may be assumed to have 40°C to be shown in [Table 1], but the cables are not limited thereto, and the temperature of the heated cable may vary depending on the amount of power applied to each power cable.

[Table 1]

| EAB | Unaged | At 10 years of aging | At 20 years of aging | At 30 years of aging | At 40 years of aging | At 50 years of aging | At 60 years of aging |
|---|---|---|---|---|---|---|---|
| Heated cable (90°C ) | 800% | 700% | 600% | 500% | 400% | 300% | 200% |
| Non-heated cable (40°C ) | 800% | 780% | 760% | 740% | 720% | 700% | 680% |

Here, the elongation at break for each test cycle of the heated cable and the non-heated cable may be derived from Arrhenius equation, and the Arrhenius equation may be expressed as the following equation.

[Equation 1]

$$k = A\, e^{-\frac{E_a}{RT}}$$

In Equation 1, k is a rate constant, T is an absolute temperature, A is an Arrhenius constant, Ea is activation energy, and R is a gas constant. That is, the more frequent collisions, the lower activation energy, and the higher a temperature, the more a reaction rate increases, and when the reaction rate increases, an aging rate becomes faster.

That is, when it is intended to monitor the age state of a power cable to which power has been applied for a long time, the age state thereof may be derived by measuring the elongation at break of a target power cable which is arranged at a location adjacent to the power cable whose age state is to be monitored and is exposed thereto for a predetermined period. In this case, since the target power cable is a non-heated cable to which power is not applied, the elongation at break 10 of the non-heated cable of 40°C may be derived.

When the elongation at break 10 of the non-heated cable of 40°C is 790%, the elongation at break 20 of the heated cable may be derived as 750% by being calculated from the relational expression, and the elongation at break 10 of the non-heated cable of 90°C may be determined to have aged for about 5 years.

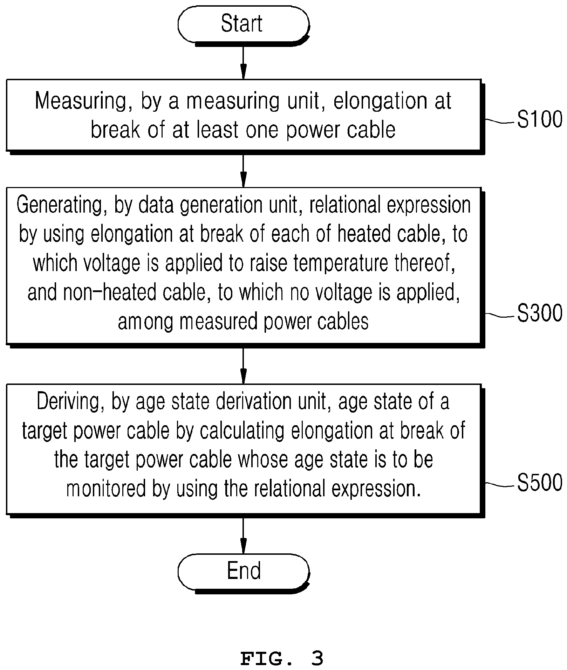

FIG. 3 is a flowchart illustrating the method for monitoring the age state of a power cable according to an embodiment.

As illustrated in FIG. 3, the method for monitoring the age state of a power cable according to an embodiment may include measuring at S100, generating data at S300, and deriving an age state at S500.

In the measuring at S100, the measuring unit 100 measures the elongation at break of at least one power cable.

In the generating of data at S300, the data generation unit 300 generates the relational expression by using the elongation at break of each of the heated cable to which a voltage is applied to raise a temperature thereof and the non-heated cable to which no voltage is applied among the measured power cables.

Here, in the generating of data at S300, by using the elongation at break measured from each of the heated cable and the non-heated cable, a graph showing a change in an age state over time may be generated.

In the deriving of an age state at S500, the age state derivation unit 500 calculates the elongation at break of the target power cable whose age state is to be monitored by using the relational expression and derives the age state of the target power cable.

Here, in the deriving of an age state at S500, the elongation at break 10 of the non-heated cable corresponding to the elongation at break of the target power cable may be derived, and the derived elongation at break 10 of the non-heated cable may be calculated by using the relational expression to derive the elongation at break 20 of the heated cable.

Although the present disclosure has been described in detail through representative embodiments above, those skilled in the art will understand that various modifications may be made to the above-described embodiments without departing from the scope of the present disclosure. Therefore, the scope of rights of the present disclosure should not be limited to the described embodiments, but should be determined not only by the claims to be described later, but also by all changes or modified forms derived from concepts equivalent to the claims.

**<Description of the Reference Numerals in the Drawings>**

100: Measuring unit 300: Data generation unit
500: Age state derivation unit
10: Elongation at break of a non-heated cable 20: Elongation at break of a heated cable

**Claims**

1. A system for monitoring an age state of a power cable, the system comprising:

   a measuring unit configured to measure elongation at break of at least one power cable;
   a data generation unit configured to generate a relational expression by using elongation at break of each of a heated cable to which a voltage is applied to raise a temperature thereof and a non-heated cable to which no voltage is applied, among the measured power cables; and
   an age state derivation unit configured to derive an age state of a target power cable by calculating elongation at break of the target power cable whose age state is to be monitored by using the relational expression.

2. The system of claim 1, wherein the target power cable is a non-heated cable exposed for a predetermined period of time to a location adjacent to a power cable to which a voltage is applied.

3. The system of claim 1, wherein the data generation unit generates a graph showing a change in an age state over time by using the elongation at break of each of the heated cable and the non-heated cable.

4. The system of claim 1, wherein the age state derivation unit derives an aging rate according to a temperature of the heated cable and a temperature of the non-heated cable.

5. The system of claim 1, wherein the age state derivation unit derives elongation at break of a non-heated cable corresponding to the elongation at break of the target power cable and calculates the derived elongation at break of the non-heated cable by using the relational expression to derive elongation at break of a heated cable.

6. The system of claim 1, wherein the heated cable is a power cable with a temperature of 70°C to 110°C, and the non-heated cable is a power cable with a temperature of 20°C to 60°C.

7. The system of claim 1, wherein the age state is derived in any one unit of seconds, minutes, hours, days, months, and years.

8. A method for monitoring an age state of a power cable, the method comprising:

   measuring, by a measuring unit, elongation at break of at least one power cable;
   generating data by a data generation unit generating a relational expression by using elongation at break of each of a heated cable to which a voltage is applied to raise a temperature thereof and a non-heated cable to which no voltage is applied, among the measured power cables; and
   deriving, by an age state derivation unit, an age state of a target power cable by calculating elongation at break of the target power cable whose age state is to be monitored by using the relational expression.

| Measuring unit | — 100 |

↓

| Data generation unit | — 300 |

↓

| Age state derivation unit | — 500 |

FIG. 1

FIG. 2

EP 4 528 294 A1

FIG. 3

| INTERNATIONAL SEARCH REPORT | International application No.  **PCT/KR2023/006513** |
|---|---|

**A. CLASSIFICATION OF SUBJECT MATTER**

**G01R 31/08**(2006.01)i; **H05B 3/56**(2006.01)i

According to International Patent Classification (IPC) or to both national classification and IPC

**B. FIELDS SEARCHED**

Minimum documentation searched (classification system followed by classification symbols)

G01R 31/08(2006.01); G01N 1/04(2006.01); G01N 27/04(2006.01); G01N 3/42(2006.01); G01N 3/54(2006.01); H02J 13/00(2006.01); H02J 3/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 전력 케이블(power cable), 파단 연신율(Elongation at Break, EAB), 수명(life), 예측(prediction)

**C. DOCUMENTS CONSIDERED TO BE RELEVANT**

| Category* | Citation of document, with indication, where appropriate, of the relevant passages | Relevant to claim No. |
|---|---|---|
| A | KR 10-2012-0008123 A (KOREA ELECTROTECHNOLOGY RESEARCH INSTITUTE) 30 January 2012 (2012-01-30)  See paragraphs [0017]-[0019]; claim 1; and figures 1-7. | 1-8 |
| A | KR 10-2012-0024043 A (KOREA ELECTRIC POWER CORPORATION) 14 March 2012 (2012-03-14)  See paragraphs [0015]-[0049]; and figures 1-4. | 1-8 |
| A | US 2015-0028885 A1 (ATOMIC ENERGY COUNCIL - INSTITUTE OF NUCLEAR ENERGY RESEARCH) 29 January 2015 (2015-01-29)  See paragraphs [0013]-[0017]. | 1-8 |
| A | WO 2013-033387 A1 (TOLLGRADE COMMUNICATIONS, INC.) 07 March 2013 (2013-03-07)  See paragraphs [0007]-[0018]. | 1-8 |

☑ Further documents are listed in the continuation of Box C.      ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search  **04 September 2023** | Date of mailing of the international search report  **04 September 2023** |
|---|---|
| Name and mailing address of the ISA/KR  **Korean Intellectual Property Office**  **Government Complex-Daejeon Building 4, 189 Cheongsa-ro, Seo-gu, Daejeon 35208** | Authorized officer |
| Facsimile No. **+82-42-481-8578** | Telephone No. |

Form PCT/ISA/210 (second sheet) (July 2022)

**INTERNATIONAL SEARCH REPORT**

| | International application No. |
|---|---|
| | **PCT/KR2023/006513** |

## C.    DOCUMENTS CONSIDERED TO BE RELEVANT

| Category* | Citation of document, with indication, where appropriate, of the relevant passages | Relevant to claim No. |
|---|---|---|
| A | 유성구 등. LMBP 신경회로망을 이용한 원전용 제어케이블의 상태 예측 시스템 설계. Journal of Institute of Control, Robotics and Systems (2017). 23(3), March 2017, pp. 194-198 (YOO, Sung Goo et al. Design of a Control Cable Condition Prediction System for Nuclear Power Plants using LMBP Neural Networks).<br>[Retrieved on 16 August 2023]. Retrieved from <https://www.dbpia.co.kr/Journal/articleDetail?nodeId=NODE07116644>.<br>See pages 194-197. | 1-8 |

Form PCT/ISA/210 (second sheet) (July 2022)

## INTERNATIONAL SEARCH REPORT
**Information on patent family members**

International application No.

**PCT/KR2023/006513**

| Patent document cited in search report | | | Publication date (day/month/year) | Patent family member(s) | | | Publication date (day/month/year) |
|---|---|---|---|---|---|---|---|
| KR | 10-2012-0008123 | A | 30 January 2012 | None | | | |
| KR | 10-2012-0024043 | A | 14 March 2012 | KR | 10-1161776 | B1 | 03 July 2012 |
| US | 2015-0028885 | A1 | 29 January 2015 | US | 09395279 | B2 | 19 July 2016 |
| WO | 2013-033387 | A1 | 07 March 2013 | EP | 2751895 | A1 | 09 July 2014 |
| | | | | EP | 2751895 | B1 | 13 June 2018 |
| | | | | EP | 2751896 | A1 | 09 July 2014 |
| | | | | EP | 2751896 | B1 | 11 July 2018 |
| | | | | EP | 2815479 | A1 | 24 December 2014 |
| | | | | EP | 2815479 | B1 | 04 January 2017 |
| | | | | US | 10041968 | B2 | 07 August 2018 |
| | | | | US | 2013-0054162 | A1 | 28 February 2013 |
| | | | | US | 2013-0054183 | A1 | 28 February 2013 |
| | | | | US | 2013-0205900 | A1 | 15 August 2013 |
| | | | | US | 2017-0030943 | A1 | 02 February 2017 |
| | | | | US | 2019-0067941 | A1 | 28 February 2019 |
| | | | | US | 9562925 | B2 | 07 February 2017 |
| | | | | US | 9647454 | B2 | 09 May 2017 |
| | | | | WO | 2013-033374 | A1 | 07 March 2013 |
| | | | | WO | 2013-123055 | A1 | 22 August 2013 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 100880440